Europäisches Patentamt

European Patent Office

Office européen des brevets

(19)

(11) EP 0 682 828 B1

(12) FASCICULE DE BREVET EUROPEEN

(45) Date de publication et mention
de la délivrance du brevet:
**02.06.1999 Bulletin 1999/22**

(21) Numéro de dépôt: **95902834.1**

(22) Date de dépôt: **06.12.1994**

(51) Int Cl.$^6$: **H03M 13/22**

(86) Numéro de dépôt international:
**PCT/FR94/01417**

(87) Numéro de publication internationale:
**WO 95/16311 (15.06.1995 Gazette 1995/25)**

(54) **PROCEDE D'ENTRELACEMENT ET DE DESENTRELACEMENT EN BLOC ET DISPOSITIF DE MISE EN OEUVRE**

Verfahren und Vorrichtung zur Block Verschachtelung und Entschachtelung

BLOCK INTERLEAVING AND DEINTERLEAVING METHOD AND DEVICE THEREFOR

(84) Etats contractants désignés:
**DE FR GB IT**

(30) Priorité: **07.12.1993 FR 9314646**

(43) Date de publication de la demande:
**22.11.1995 Bulletin 1995/47**

(73) Titulaire: **THOMSON multimedia**
**92648 Boulogne Cédex (FR)**

(72) Inventeur: **HANNA, Charaf**
**F-92402 Courbevoie Cédex (FR)**

(74) Mandataire: **Zhang, Jianguo et al**
**THOMSON multimedia,**
**46 quai A. Le Gallo**
**92648 Boulogne Cédex (FR)**

(56) Documents cités:
EP-A- 0 370 444          EP-A- 0 405 673
EP-A- 0 467 717          DE-A- 3 539 592
US-A- 3 652 998

- **PATENT ABSTRACTS OF JAPAN vol. 9, no. 318 (E-366) 13 Décembre 1985 & JP,A,60 152 130 (NEC HOME ELECTRONICS KK) 10 Août 1985**
- **IEEE TRANSACTIONS ON INFORMATION THEORY, vol.16, no.3, Mai 1970, NEW YORK US pages 338 - 345 RAMSEY 'Realization of optimum interleavers'**
- **ELECTRONICS AND COMMUNICATIONS IN JAPAN, vol.67, no.10, Octobre 1984, NEW YORK US pages 57 - 65 OHUE ET AL 'Block interleavers with maximum pulse distance'**
- **PATENT ABSTRACTS OF JAPAN vol. 7, no. 152 (P-208) 5 Juillet 1958 & JP,A,58 062 752 (NIPPON DENKI KK) 14 Avril 1983**
- **PATENT ABSTRACTS OF JAPAN vol. 17, no. 182 (P-1518) 8 Avril 1993 & JP,A,04 335 266 (AIWA CO LTD) 24 Novembre 1992**

## Description

La présente invention se rapporte à un procédé d'entrelacement et de désentrelacement en blocs de données, ainsi qu'à un dispositif mettant en oeuvre ce procédé. L'invention s'applique notamment à l'entrelacement de données numériques avant leur transmission et au désentrelacement après réception.

Il est connu de par l'art antérieur d'associer les techniques de détection et de correction d'erreur et d'entrelacement pour fiabiliser la transmission de données numériques.

Pour un code correcteur d'erreur tel que le code Reed-Solomon, on annexe au paquet de mots binaires à transmettre un certain nombre de mots supplémentaires, permettant de corriger jusqu'à un nombre maximum donné d'erreurs de transmission. Lorsque ce maximum d'erreurs est dépassé, le code correcteur n'est plus suffisant. Ceci peut notamment être le cas si une salve d'erreurs corrompt plusieurs mots contigus.

Pour augmenter l'efficacité du code correcteur, on procède à l'entrelacement de plusieurs paquets de données. Cette technique consiste à transmettre successivement des mots issus de paquets différents. En ne transmettant pas chaque paquet d'un seul coup, il est possible de répartir les conséquences d'une salve d'erreurs sur plusieurs paquets, et de rester ainsi dans les limites du code correcteur.

L'entrelacement, au niveau de l'organe émetteur, est généralement réalisé en écrivant les données dans une mémoire dans un certain ordre, et en les relisant dans un ordre différent pour la transmission. Le désentrelacement, au niveau du récepteur est réalisé de manière inverse, en écrivant les données dans la mémoire de désentrelacement suivant l'ordre de lecture de la mémoire d'entrelacement, et en relisant les données suivant l'ordre d'écriture dans la mémoire d'entrelacement.

Soient à entrelacer P paquets, comprenant chacun L octets. Ces P paquets constituent un bloc B. On dit que l'on réalise un entrelacement de profondeur P en réarrangeant les octets des P paquets de manière à séparer deux octets successifs d'un paquet donné par P-1 octets issus des P-1 autres paquets.

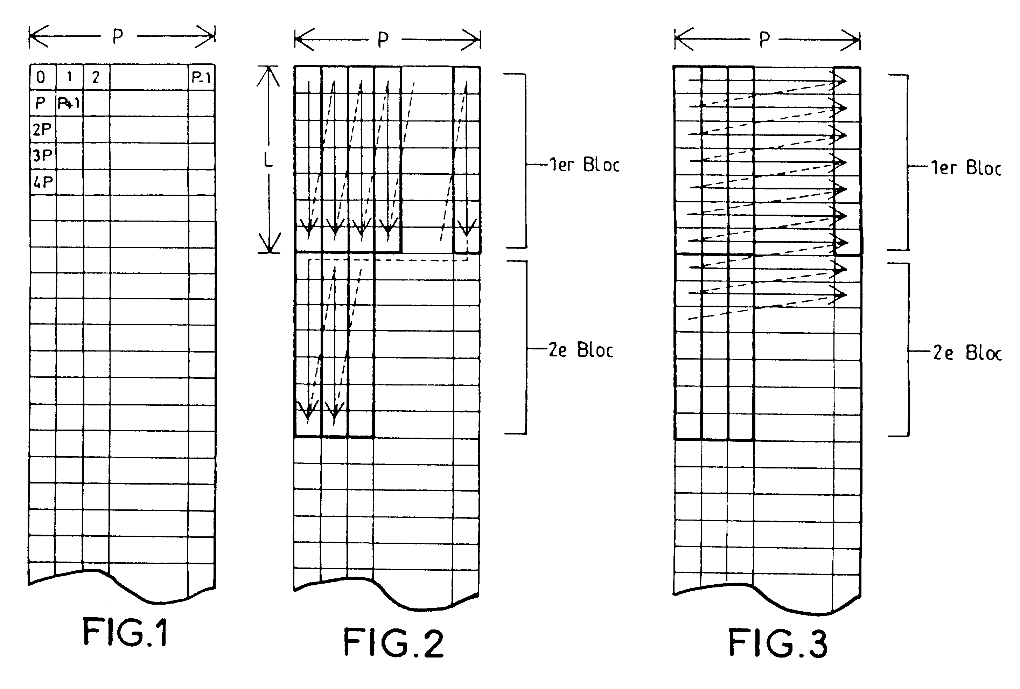

La figure 1 montre une mémoire permettant de réaliser cet entrelacement. Pour simplifier l'exposé de l'art antérieur, cette mémoire comporte P colonnes d'octets. Les adresses vont en s'incrémentant de gauche à droite et de haut en bas, tel que le montre la figure 1.

L'écriture dans cette mémoire se fait en écrivant le premier octet du premier paquet à l'adresse 0, le second octet à l'adresse P, et ainsi de suite jusqu'au demier octet (octet L-1) à l'adresse (L-1)P. Ces adresses correspondent à la première colonne de la mémoire. De la même façon, on écrira le second paquet aux adresses 1, P+1, ... (L-1)P+1 de la seconde colonne. On procède ainsi jusqu'au dernier paquet et la dernière colonne. L'ordre d'écriture est illustré à la figure 2.

En généralisant, on peut dire que l'octet I (avec I $\in$ [1,L]) du paquet p (avec p $\in$ [1,P]) du bloc b (avec b $\in$ [1,B]) s'écrira à l'adresse (b-1)LP+(p-1)+(1-1)P de la mémoire.

La lecture s'effectuera dans l'ordre des adresses, c'est à dire en lisant ligne après ligne (voir figure 3). On lit donc d'abord les premiers octets de tous les paquets, suivis par les seconds octets et ainsi de suite. L'entrelacement est donc bien réalisé.

Ce schéma d'écriture-lecture implique qu'il est nécéssaire d'écrire une grande partie des données d'un bloc B avant de pouvoir en lire. Concrètement, on doit avoir écrit E=(L-1)(P-1)+1 octets avant de lire le premier octet à l'adresse 0. Si ce critère n'est pas respecté, la lecture se fera à un moment ou à un autre à une adresse non encore balayée par l'écriture.

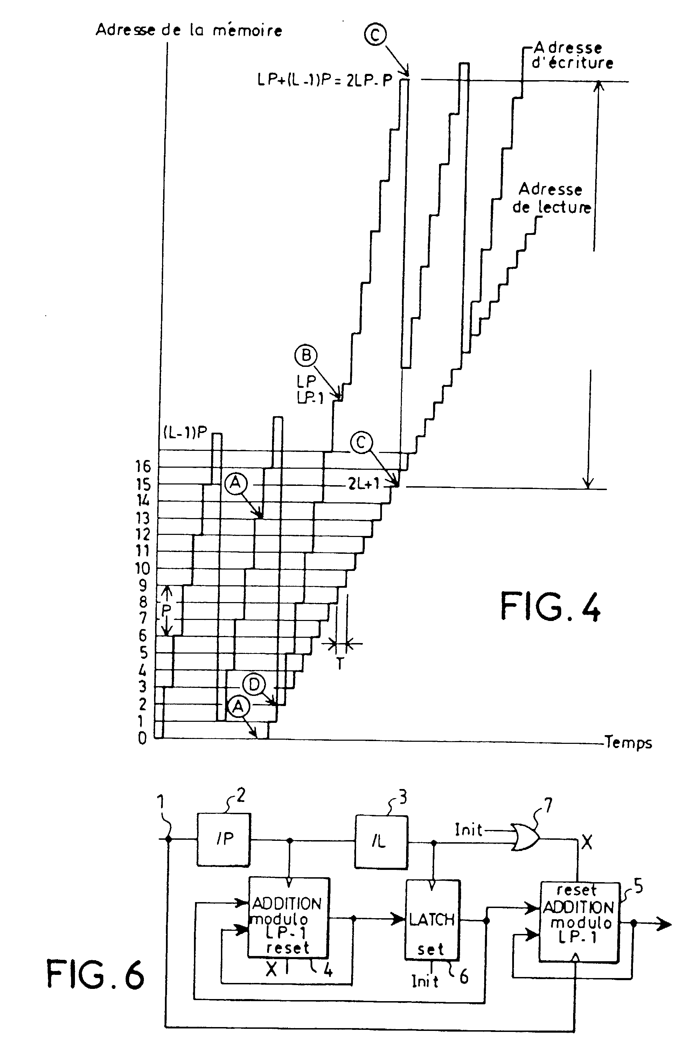

La figure 4 illustre l'évolution de l'adresse d'écriture et de l'adresse de lecture dans le cas où P est pris égal à 3 et L est pris égal à 7. Le temps est représenté en abscisse, tandis que les adresses de la mémoire d'entrelacement sont en ordonnée. T représente un cycle élémentaire d'horloge. On supposera que pour un cycle donné, l'écriture est effectuée avant la lecture. De ce fait, lorsque l'adresse d'écriture est égale à l'adresse de lecture pour un même cycle T, la donnée correspondante est d'abord écrite avant d'être relue pendant le même cycle T.

La courbe en dents de scie 1 représente les adresses d'écriture, tandis que la courbe en escalier 2 représente les adresses de lecture. La courbe 1 réalise 6 sauts de 3 adresses à partir de l'adresse 0, ceci correspondant à l'écriture du premier paquet (7 octets) dans la première colonne. L'écriture reprend alors en haut de la seconde colonne, avec l'adresse 1. Au point A, c'est à dire après l'écriture de (L-1)(P-1)+1=13 octets, la lecture peut commencer à l'adresse 0, pendant le même cycle qu'est effectuée l'écriture du treizième octet. L'adresse de lecture s'incrémentera d'une unité à chaque cycle d'horloge. On notera qu'au point D, les deux courbes se rejoignent. Si la lecture des données avait été entreprise plus tôt qu'au 13e cycle d'écriture, par exemple au 12e cycle, on aurait tenté de lire à l'adresse 2 avant même d'y avoir écrit une donnée.

Au point B, l'écriture du premier bloc de P paquets est achevée, la dernière valeur ayant été écrite à l'adresse (LP-1)=20. L'écriture du prochain bloc commence alors à l'adresse LP=21, comme illustré à la figure 2. En fin de bloc, le saut d'adresse est donc de 1.

La taille minimale Delta de la mémoire est égale à la différence maximale entre l'adresse d'écriture et l'adresse de lecture. Sur le schéma de la figure 4, on peut voir que cette différence est maximale au point C. L'adresse d'écriture est LP+(L-1)P. A ce moment LP+L octets ont été écrits. L'adresse de lecture est alors LP+L-E=LP+L-(LP-L-P+2)=2L+P-2.

On obtient donc Delta=LP+(L-1)P-(2L+P-2)+1 = 2(L-1)(P-1)+1.

En considérant l'exemple numérique précédent, la taille minimale de la mémoire aurait été de 25 octets.

L'invention a pour but de présenter un procédé d'entrelacement permettant de réduire la taille des mémoires nécessaires, tout en simplifiant l'adressage de ces mémoires.

L'invention a pour objet un procédé d'entrelacement de blocs de P paquets comportant chacun L mots binaires, selon lequel après avoir lu à une adresse donnée une donnée correspondant à un bloc b-1, on inscrit à la même adresse une donnée correspondant au bloc b, ledit procédé étant caractérisé en ce que les adresses de la mémoire d'entrelacement allant de 0 à LP-1, la progression des adresses de lecture/écriture pour un bloc b est telle que:

$$a_b(n)=(a_b(n-1)+(L^{(b-x)})) \bmod (LP-1) \text{ pour } n \in \, ]0, LP-1[, \text{ n entier,}$$

avec
$$a_b(0)=0$$
$$a_b(LP-1)=LP-1$$
et
$$b \in [1,\infty[, \text{ b entier}$$
$$x \leq b, \text{ x entier.}$$

L'invention a aussi pour objet un procédé d'entrelacement de blocs de P paquets comportant chacun L mots binaires, selon lequel après avoir lu à une adresse donnée une donnée correspondant à un bloc b-1, on inscrit à la même adresse une donnée correspondant au bloc b, ledit procédé étant caractérisé en ce que si $a_b(n)$ est la suite des adresses de lecture/écriture dans la mémoire d'entrelacement dont les adresses vont de 0 à LP-1, la relation entre la suite d'adresses du bloc b et la suite d'adresses du bloc b+1 est:

$$a_{b+1}(n)=L \times (a_b(n)) \text{ modulo (LP-1) si } n \neq LP-1,$$

$$a_{b+1}(LP-1)=LP-1.$$

Ainsi, on remplit la mémoire en inscrivant le bloc suivant au fur et à mesure que l'on lit le bloc précédent. Du fait de l'égalité, à tout moment, des adresses de lecture et d'écriture, l'adressage de la mémoire d'entrelacement est grandement simplifié. La taille de la mémoire nécessaire n'est alors que de PL mots binaires.

Dans le premier cas, il s'agit d'une progression des adresses pour un bloc b qui ne nécéssite pas la connaissance des adresses concernant le bloc b-1. Il suffit de connaître L, P, b et x.

Dans le second cas, la relation donne les renseignements nécessaires pour passer des adresses correspondant à un bloc b à celles correspondant au bloc b+1. Il suffit de connaître les adresses correspondant au bloc b, et les valeurs de L et P.

Bien évidemment, il est possible de passer d'un bloc b à un bloc b+m en appliquant m fois cette relation.

Selon un mode de réalisation particulier de l'invention, il n'y a pas de lecture de données pendant l'écriture des données du premier bloc. Les données qui pourraient être lues à ce moment n'ont normalement pas de sens.

Selon un mode de réalisation particulier de l'invention, il y a une lecture de données pendant l'écriture du premier bloc, et les résultats de cette lecture ne sont pas utilisés. Il n'y a pas alors d'exception quant au traitement du premier bloc.

L'invention a aussi pour objet un dispositif de génération d'adresses d'entrelacement et/ou de désentrelacement de blocs de P paquets, chaque paquet comportant L mots binaires, caractérisé en ce qu'il comprend des moyens de génération, pour un bloc d'ordre b, d'une constante $L^{(b-x)}$ modulo (LP-1) avec b entier et x entier constant inférieur ou égal à b, et des moyens d'addition d'un multiple par m (entier variant de 0 à LP-1) de ladite constante à une adresse de base, chaque valeur résultante étant prise modulo (LP-1) si ladite valeur est différente de (LP-1) ou strictement supérieure à (LP-1), le résultat de cette addition constituant l'adresse de lecture du bloc b et l'adresse d'écriture du bloc b+1.

Selon un mode de réalisation particulier, le dispositif de génération d'adresses est caractérisé en ce qu'il reçoit une horloge à la fréquence des octets à entrelacer, le dispositif comportant un diviseur d'horloge par P recevant l'horloge CO, un diviseur d'horloge par L, recevant en entrée la sortie du diviseur par P, deux additionneurs modulo (LP-1), le second additionneur n'effectuant le calcul modulo que si le résultat de son addition est soit différent, soit strictement supérieur à (LP-1), ainsi qu'un registre tampon, le premier additionneur possédant une entrée horloge recevant le signal de sortie du diviseur par P, les deux entrées de ce premier additionneur recevant respectivement la sortie du même additionneur et la sortie du registre tampon, l'additionneur possédant enfin une entrée de remise à zéro, commandée par le signal issu du diviseur par L ou un signal d'initialisation, la sortie du premier additionneur étant d'autre part reliée à l'entrée dudit registre tampon, ce dernier possédant aussi une entrée SET, reliée au signal d'initialisation et permettant de le mettre à la valeur 1, ainsi qu'une entrée d'horloge, reliée au signal issu du diviseur par L, la sortie du registre tampon étant reliée à une entrée de chacun des deux additionneurs, le second additionneur recevant sur son autre entrée sa propre sortie, qui constitue aussi la sortie du dispositif et fournit les adresses de lecture/écriture, l'entrée d'horloge du second additionneur étant reliée au signal CO, l'entrée de remise à zéro du second additionneur étant reliée à un OU logique à deux entrées, qui reçoit la sortie du diviseur par L et le signal d'initialisation.

D'autres avantages et caractéristiques de l'invention apparaîtront à travers la description d'un mode de réalisation particulier de l'invention, illustré par les figures jointes, parmi lesquelles:

- la figure 1, déjà décrite, représente le schéma d'adressage d'une mémoire d'entrelacement
- la figure 2, déjà décrite, représente un schéma d'écriture de données connu dans ladite mémoire,
- la figure 3, déjà décrite, représente un schéma de lecture de données connue de ladite mémoire,
- la figure 4, déjà décrite, représente un diagramme d'évolution simultané des adresses de lecture et d'écriture,
- la figure 5 représente un diagramme d'évolution des adresses d'écriture et de lecture dans une autre mémoire d'entrelacement, ladite évolution étant en accord avec un exemple de mise en oeuvre de la méthode inventive,
- la figure 6 représente un exemple de réalisation d'un dispositif de mise en oeuvre de l'invention,
- les figures 7 et 8 représentent d'autres exemples de réalisation de dispositifs mettant en oeuvre l'invention.

Selon le présent mode de réalisation de l'invention, on cherche à réaliser l'entrelacement, de profondeur P, de groupes de P paquets de L octets en blocs B de PL octets chacun. Conformément à l'invention, on utilisera une mémoire d'entrelacement de PL octets. Pour simplifier les explications, cette mémoire organisée en matrice de P colonnes de L octets, les espaces mémoire étant adressés de 0 à PL-1 en balayant la mémoire ligne par ligne, du haut à gauche vers le bas à droite.

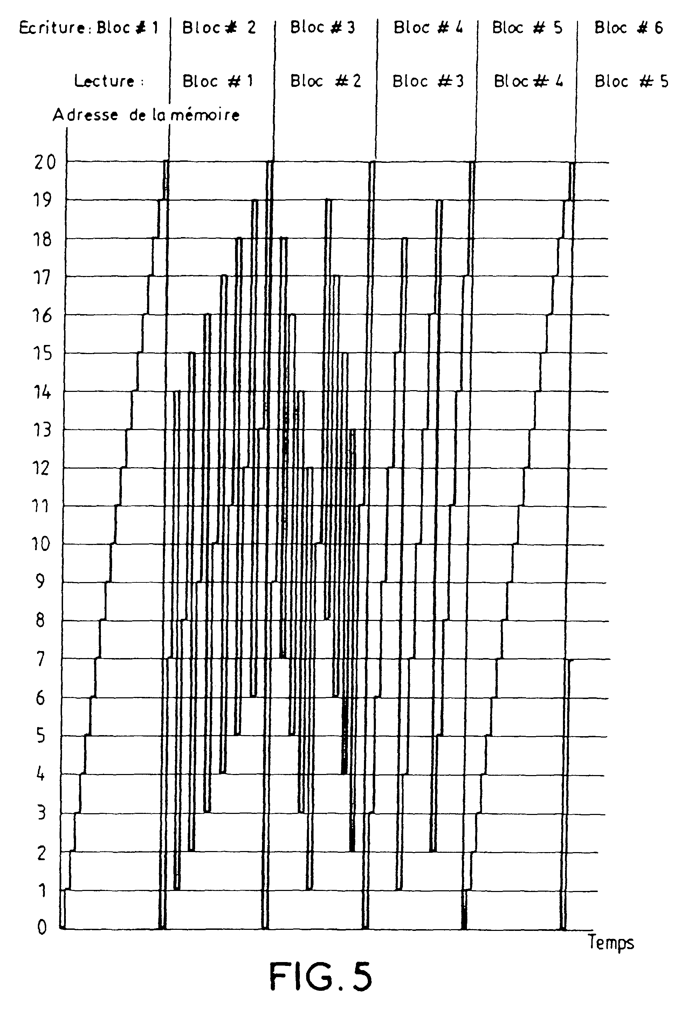

La figure 5 donne l'évolution des adresses d'écriture et de lecture conformément au présent exemple de réalisation. P et L sont pris respectivement égaux à 3 et 7. La mémoire comporte donc 21 cases, d'adresses 0 à 20, données en ordonnée. Le temps figure en abscisse.

La première étape à entreprendre consiste à écrire le premier bloc (bloc b=1). Pour ce premier bloc, aucune lecture n'est effectuée. Pour prendre un exemple simple de progression des adresses d'écriture de ce premier bloc, on choisit une incrémentation d'une adresse à chaque écriture de donnée, en partant de l'adresse 0.

Le diagramme de l'évolution des adresses d'écriture du premier bloc est donné dans la première colonne de la figure 5.

La seconde étape consiste à lire les données écrites pendant la période d'écriture du bloc précédent, dans un ordre correspondant à l'entrelacement. Les adresses de lecture sont calculées à partir des adresses d'écriture du premier bloc. Dans le présent exemple, les adresses se confondent avec l'ordre d'écriture. Si les P paquets sont écrits consécutivemment dans la mémoire, il faudra lire les octets toutes les L adresses, en partant de l'adresse 0 (on lit tout d'abord les premiers octets des P paquets, puis les seconds octets etc..). La fonction donnant les adresses dans ce cas est:

f(X)=LX modulo (LP-1) lorsque LX≠LP-1
f(X)=LP-1 lorsque LX=LP-1
avec X variant de 0 à LP-1.

On notera que, lorsque LX est égal à LP-1, on utilise la valeur LP-1 et non la valeur 0.

Conformément à l'invention, lorsque l'on lit les données du premier bloc, on écrit, aux adresses de lecture, les données correspondant au second bloc. Cette écriture est effectuée dans le même ordre que précédemment, c'est à dire que l'écriture se fait paquet par paquet, en partant du premier octet du premier paquet. Les adresses de lecture/écriture sont bien évidemment choisies de façon à réaliser l'entrelacement, et sont calculées en utilisant la fonction f.

Les adresses de lecture du second bloc sont définies en appliquant $f^2$ au lieu de f, et ainsi de suite pour les blocs suivants. On obtient ainsi le tableau d'adresses de lecture/écriture suivant:

| 0 | 1 | 2 | 3 | 4 | 5 | 6 | 7 | 8 | 9 | 10 | 11 | 12 | 13 | 14 | 15 | 16 | 17 | 18 | 19 | 20 |
|---|---|---|---|---|---|---|---|---|---|----|----|----|----|----|----|----|----|----|----|----|
| 0 | 7 | 14 | 1 | 8 | 15 | 2 | 9 | 16 | 3 | 10 | 17 | 4 | 11 | 18 | 5 | 12 | 19 | 6 | 13 | 20 |
| 0 | 9 | 18 | 7 | 16 | 5 | 14 | 3 | 12 | 1 | 10 | 19 | 8 | 17 | 6 | 15 | 4 | 13 | 2 | 11 | 20 |
| 0 | 3 | 6 | 9 | 12 | 15 | 18 | 1 | 4 | 7 | 10 | 13 | 16 | 19 | 2 | 5 | 8 | 11 | 14 | 17 | 20 |
| 0 | 1 | 2 | 3 | 4 | 5 | 6 | 7 | 8 | 9 | 10 | 11 | 12 | 13 | 14 | 15 | 16 | 17 | 18 | 19 | 20 |

La première ligne correspond aux adresses d'écriture du premier bloc, la seconde aux adresses de lecture du premier bloc et aux adresses d'écriture du second bloc, et ainsi de suite. Le passage d'une ligne à la ligne suivante dans une même colonne se fait par application de la fonction f.

On notera que les première et cinquième lignes sont identiques, dans le cadre de l'exemple numérique utilisé. Cette périodicité peut être utilisée pour faciliter les calculs des adresses, ou leur mémorisation en mémoire morte.

La figure 5 donne l'équivalent graphique du tableau ci-dessus.

Il est à noter que le désentrelacement peut se faire en appliquant soit le procédé inventif, soit tout autre procédé de désentrelacement, le flux de données entrelacées émis par le dispositif d'entrelacement inventif ne se distinguant pas du flux créé par un autre dispositif d'entrelacement.

Selon une variante de ce mode de réalisation, et dans le but de simplifier les circuits, on effectue une lecture de la manière décrite aussi pendant l'écriture de premier bloc. Simplement on ne tiendra pas compte des résultats de cette première lecture.

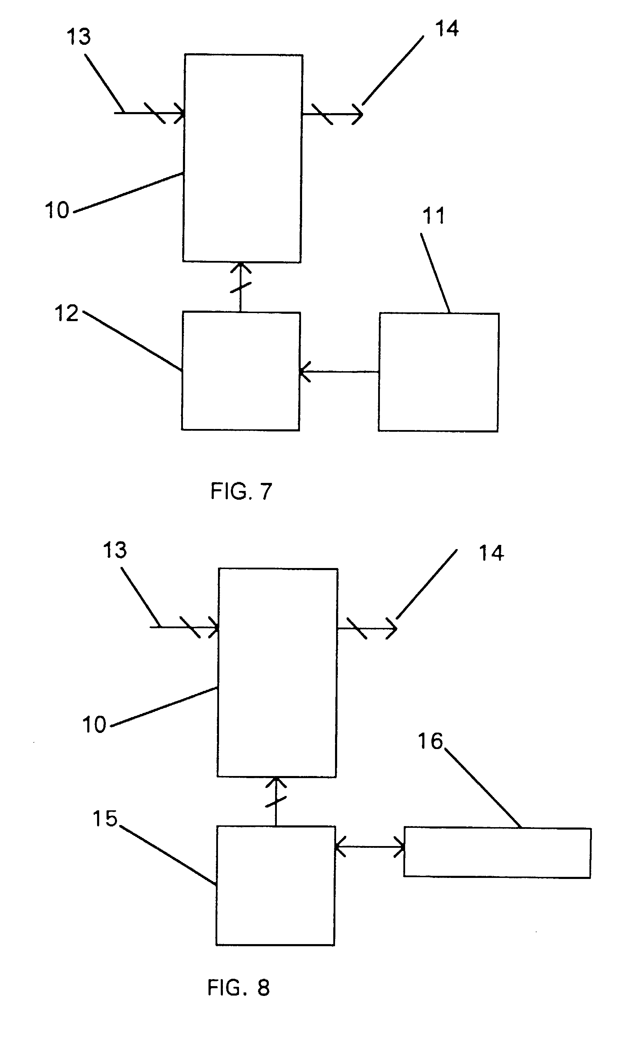

La figure 6 représente schématiquement un exemple de réalisation d'un circuit séquenceur d'adresses mettant en oeuvre l'invention. A la base de ce circuit est la caractéristique selon laquelle, pour un bloc donné, le passage d'une adresse à la suivante se fait par addition d'une constante, le résultat étant pris modulo la taille de la mémoire moins 1 au cas où ce résultat dépasse l'adresse maximale de la mémoire. Par exemple, pour la première ligne du tableau ci-dessus, la constante est de 1, pour la seconde ligne, elle est de 7 (7 étant inférieur ou égal à 20, adresse maximale), pour la troisième, elle est de 9 ($7^2$ modulo 20), pour la quatrième, elle est de 3 ($7^3$ modulo 20). Pour la dernière ligne, on retombe sur une constante de 1 (7 puissance 4 modulo 20). Les puissances correspondent aux puissances de la fonction f.

Le circuit de la figure 6 comporte une entrée 1 recevant un signal d'horloge (CO) à la fréquence des octets à entrelacer, un diviseur d'horloge par P (2) recevant l'horloge CO, ainsi qu'un diviseur d'horloge par L (3), recevant en entrée la sortie du diviseur par P (2).

On a donc à disposition trois horloges, donnant une impulsion respectivement pour tous les octets, tous les P octets et tous les blocs (de PL octets).

Le circuit séquenceur comporte en outre deux additionneurs modulo (LP-1) 4 et 5, ainsi qu'un registre tampon (ou "latch") 6. Le rôle du premier additionneur 4 est de calculer la constante mentionnée ci-dessus, celle-ci changeant tous les PL octets. Le latch 6 mémorisé cette valeur, qui est utilisée par le second additionneur 5 pour calculer les adresses de lecture/écriture proprement dites.

L'additionneur 4 possède une entrée horloge recevant le signal de sortie du diviseur par P 2. Les deux entrées de cet additionneur recoivent respectivement la sortie du même additionneur 4 et la sortie du registre tampon 6. L'additionneur 4 possède enfin une entrée d'initialisation RESET, qui permet la remise à zéro et qui est commandée par le signal issu du diviseur par L 3 ou par le signal d'initialisation INIT.

La sortie de l'additionneur 4 est reliée à l'entrée du registre tampon 6. Ce dernier possède aussi une entrée SET, reliée à un signal d'initialisation INIT et permettant de le mettre à la valeur 1, ainsi qu'une entrée d'horloge, reliée au signal issu du diviseur par L 3. La sortie du registre tampon 6 est reliée à une entrée de chacun des additionneurs 4 et 6.

L'additionneur 5 reçoit sur son autre entrée sa propre sortie, qui constitue aussi la sortie du circuit séquenceur et fournit les adresses de lecture/écriture. Son entrée d'horloge est reliée au signal CO. L'entrée RESET de l'additionneur est reliée à un OU logique 7 à deux entrées, qui reçoivent la sortie du diviseur par L 3 et au signal d'initialisation INIT.

Le fonctionnement du circuit séquenceur est le suivant: on envoie une impulsion INIT aux entrées mentionnées ci-haut. Les sorties des deux additionneurs sont alors à zéro, tandis que la sortie du registre tampon est à 1. La sortie du circuit indique donc l'adresse 0.

Pour un cycle de l'horloge CO, on effectue d'abord la lecture de la donnée du bloc précédent à l'adresse indiquée par la sortie du circuit, puis l'écriture de la donnée du bloc présent à cette même adresse de la mémoire. Il conviendra de faire attention à ce que l'adresse en sortie du circuit séquenceur reste stable pendant les cycles de lecture/écriture, le résultat de l'addition constituant l'adresse de l'octet suivant ne devant apparaître qu'une fois ces cycles terminés. On utilisera par exemple un registre tampon (non illustré) recevant la sortie du circuit séquenceur et commandé par une horloge dérivée de CO.

La première impulsion sur CO, annonçant par son front montant la stabilisation du premier octet à écrire sur le bus de données de la mémoire d'entrelacement commande l'additionneur 5, qui additionne les valeurs présentes à ses entrées. Dans le présent cas, un 1 apparaît à la sortie, après le front montant de la première impulsion sur CO. Il en va de même à chacune des impulsions suivantes sur CO. L'additionneur 5 s'incrémente donc de 0 jusqu'à LP-1, valeur après laquelle il est remis à zéro par le diviseur par L 3. Les adresses progressent donc de la façon indiquée sur la figure 5 pour le bloc 1.

Pendant ce temps, l'additionneur 4 compte une impulsion de CO sur P impulsions, son entrée reliée au registre 6 étant égale à 1. Au bout de LP impulsions sur CO, la sortie de l'additionneur présente la valeur L, mémorisée par le registre tampon 6 qui est commandé par l'impulsion issue du diviseur par L 3 à ce moment. Il conviendra de faire attention à ce que la valeur L à la sortie de l'additionneur 4 soit stabilisée avant le transfert vers le registre tampon 6.

Pour l'écriture du second bloc (et la lecture du premier), la progression des adresses se fera de L en L emplacements mémoire, comme indiquée par la valeur mémorisée par le registre tampon 6. C'est ici que la fonction modulo de l'additionneur 5 entre en jeu, de façon à ce que les adresses ne dépassent jamais l'adresse maximale de la mémoire.

Pendant ce temps, l'additionneur 4, préalablement remis à zéro, ajoute L fois L, obtenant $L^2$ modulo LP-1. Le modulo est pris après chaque addition, ce qui réduit la taille du registre accumulateur de l'additionneur. Enfin, la valeur $L^2$ mod LP-1 est mémorisée dans le registre tampon 6.

Le fonctionnement est alors identique pour tous les blocs suivants.

Selon l'exemple pris, le registre tampon 6 est initialisé à 1. Il est bien sur possible, selon d'autres modes de réalisation, de l'initialiser à une autre des valeurs $L^2$ mod LP-1, $L^3$ mod LP-1 ou L puissance 4 mod LP-1.

La partie de calcul modulo de l'additionneurs 5 est telle que le modulo n'entre en jeu que lorsque le résultat de l'addition est strictement supérieur à LP-1. En effet, étant donné les conventions prises pour l'adressage de la mémoire d'entrelacement, on n'obtiendrait jamais l'adresse LP-1 si cette précaution n'était pas prise.

Ceci est équivalent à dire que le modulo n'est mis en jeu que lorsque le résultat est différent de LP-1, étant donné que pour des valeurs strictement inférieures, le modulo ne change pas le résultat de l'addition.

On utilisera par exemple un comparateur de type connu pour comparer le résultat de l'addition à LP-1. Dans le cas où la comparaison montre que le résultat de l'addition est égal à LP-1, ou selon une variante, qu'il est inférieur ou égal, ce résultat est utilisé directement, sans qu'on en prenne le modulo. La réalisation d'un tel circuit est à la portée d'un homme de l'art.

On dispose ainsi d'un dispositif générateur d'adresse, ainsi que d'une horloge CO à la fréquence des octets. Selon un exemple de réalisation non illustré, on dispose d'une horloge à la fréquence 2×CO, un diviseur de fréquences par deux créant l'horloge CO, cette horloge double étant utilisée pour tout d'abord lire la donnée à l'adresse indiquée par le dispositif générateur, puis pour écrire la donnée du bloc suivant à cette même adresse. Les circuits d'interfaçage avec la mémoire ainsi que les bus de données sont facilement adaptables par l'homme du métier.

Bien que dans le présent mode de réalisation particulier, les données sont représentées sous la forme d'octets, d'autres formats sont bien évidemment possibles. D'autre part, le mode de réalisation particulier ci-dessus procède à un entrelacement consistant à choisir un octet à tour de rôle dans chaque paquet. L'invention est facilement adaptable à d'autres formes d'entrelacement.

La figure 7 illustre un autre exemple de réalisation d'un dispositif mettant en oeuvre l'invention. Suivant cet exemple, le dispositif comporte un microprocesseur 11, une mémoire morte 12 et la mémoire d'entrelacement 13. La mémoire morte comporte une période entière de séquences d'adresses possibles pour l'adressage de la mémoire. Il s'agit par exemple des adresses correspondant aux quatre premières lignes du tableau donné ci-dessus. Le microprocesseur 11 adresse la mémoire 12. Pour la lecture et l'écriture de chaque bloc, la mémoire 12 fournit l'adresse nécessaire au bus d'adresses de la mémoire d'entrelacement 10. Les références 13 et 14 indiquent respectivement le bus de données en entrée et en sortie de la mémoire 10.

Comme on peut le voir, le dispositif est très simple. Les adresses sont pré-mémorisées dans une mémoire morte. L'avantage de ce dispositif est entre autres le fait que peu de moyens de calcul sont nécessaires pour l'adressage.

Selon une variante de réalisation de ce dispositif, le microprocesseur 11 est remplacé par un simple compteur.

La figure 8 illustre un autre exemple de réalisation d'un dispositif conforme à l'invention. Le dispositif comporte toujours la mémoire d'entrelacement 10. Il comporte également une mémoire 16, ainsi qu'un moyen de calcul tel qu'un microprocesseur 17. La mémoire contient les constantes permettant, pour l'écriture un bloc donné, de passer d'une adresse à l'adresse suivante. Si l'on reprend l'exemple de L=7, P=3, ces constantes sont comme mentionné précédemment: 1, 7, 9 et 3. Le microprocesseur 17 lit ces constantes cycliquement au fur et à mesure des besoins. Il effectue les additions nécessaires et le calcul modulo associé. Il adresse ensuite la mémoire 10.

**Revendications**

1. Procédé d'entrelacement de blocs de P paquets comportant chacun L mots binaires, selon lequel après avoir lu à une adresse donnée une donnée correspondant à un bloc b-1, on inscrit à la même adresse une donnée correspondant au bloc b, ledit procédé étant caractérisé en ce que les adresses de la mémoire d'entrelacement allant de 0 à LP-1, la progression des adresses de lecture/écriture pour un bloc b est telle que:

$$a_b(n) = (a_b(n-1) + (L^{(b-x)})) \bmod (LP-1) \text{ pour } n \in \,]0, LP-1[, \text{ n entier,}$$

avec

$$a_b(0)=0$$
$$a_b(LP-1)=LP-1$$

et

$$b\in[1,\infty[, \text{ b entier}$$
$$x\leq b, \text{ x entier.}$$

2. Procédé selon la revendication 1, caractérisé en ce que la suite des constantes $L^{(b-x)}$ est mémorisée au préalable.

3. Procédé d'entrelacement de blocs de P paquets comportant chacun L mots binaires, selon lequel après avoir lu à une adresse donnée une donnée correspondant à un bloc b-1, on inscrit à la même adresse une donnée correspondant au bloc b, ledit procédé étant caractérisé en ce que si $a_b(n)$ est la suite des adresses de lecture/écriture dans la mémoire d'entrelacement dont les adresses vont de 0 à LP-1, la relation entre la suite d'adresses du bloc b et la suite d'adresses du bloc b+1 est:

$$a_{b+1}(n)=L\times(a_b(n)) \text{ modulo } (LP-1) \text{ si } n\neq LP-1,$$

$$a_{b+1}(LP-1)=LP-1.$$

4. Procédé selon l'une des revendications précédentes, caractérisé en ce qu'il n'y a pas de lecture de données pendant l'écriture des données du premier bloc.

5. Procédé selon l'une des revendications précédentes, caractérisé en ce que la suite d'adresses d'écriture du premier bloc est [0; ... ; LP-1].

6. Dispositif de génération d'adresses d'entrelacement et/ou de désentrelacement de blocs de P paquets, chaque paquet comportant L mots binaires, caractérisé en ce qu'il comprend des moyens de génération (4,6), pour un bloc d'ordre b, d'une constante $L^{(b-x)}$ modulo (LP-1) avec b entier et x entier constant inférieur ou égal à b, et des moyens d'addition (5) d'un multiple par m (entier variant de 0 à LP-1) de ladite constante à une adresse de base $(a_b(0))$, chaque valeur résultante étant prise modulo (LP-1) si ladite valeur est soit différente de (LP-1), soit strictement supérieure à (LP-1), le résultat de cette addition constituant l'adresse de lecture du bloc b et l'adresse d'écriture du bloc b+1.

7. Dispositif de génération d'adresses selon la revendication 6 caractérisé en ce qu'il reçoit une horloge (CO) à la fréquence des octets à entrelacer, le dispositif comportant un diviseur d'horloge par P (2) recevant l'horloge CO, un diviseur d'horloge par L (3), recevant en entrée la sortie du diviseur par P (2), deux additionneurs (4,5) modulo (LP-1), le second additionneur n'effectuant le calcul modulo que si le résultat de son addition est soit différent, soit strictement supérieur à (LP-1), ainsi qu'un registre tampon (6), le premier additionneur (4) possédant une entrée horloge recevant le signal de sortie du diviseur par P (2), les deux entrées de ce premier additionneur (4) recevant respectivement la sortie du même additionneur (4) et la sortie du registre tampon (6), l'additionneur (4) possédant enfin une entrée de remise à zéro, commandée par le signal issu du diviseur par L (3) ou un signal d'initialisation (INIT), la sortie du premier additionneur (4) étant d'autre part reliée à l'entrée dudit registre tampon (6), ce dernier possédant aussi une entrée SET, reliée au signal d'initialisation (INIT) et permettant de le mettre à la valeur 1, ainsi qu'une entrée d'horloge, reliée au signal issu du diviseur par L (3), la sortie du registre tampon (6) étant reliée à une entrée de chacun des deux additionneurs (4,5), le second additionneur (5) recevant sur son autre entrée sa propre sortie, qui constitue aussi la sortie du dispositif et fournit les adresses de lecture/écriture, l'entrée d'horloge du second additionneur (5) étant reliée au signal CO, l'entrée de remise à zéro (RESET) du second l'additionneur (5) étant reliée à un OU logique (7) à deux entrées, qui reçoit la sortie du diviseur par L (3) et le signal d'initialisation (INIT).

## Claims

1. Process for interleaving blocks of P packets each including L binary words, according to which, after having read at a given address a data item corresponding to a block b-1, a data item corresponding to the block b is written at the same address, the said process being characterized in that the addresses of the interleaving memory ranging from 0 to LP-1, the progression of the read/write addresses for a block b is such that:

$$a_b(n)=(a_b(n-1)+(L^{(b-x)}))\bmod(LP-1) \text{ for } n\in{}]0,LP-1[,\text{ n integer,}$$

with

$\qquad a_b(0)=0$

$\qquad a_b(LP-1)=LP-1$

and

$\qquad b\in[1,\infty[, \text{ b integer}$

$\qquad x\leq b, \text{ x integer.}$

2. Process according to Claim 1, characterized in that the string of constants $L^{(b-x)}$ is stored beforehand.

3. Process for interleaving blocks of P packets each including L binary words, according to which, after having read at a given address a data item corresponding to a block b-1, a data item corresponding to the block b is written at the same address, the said process being characterized in that if $a_b(n)$ is the string of read/write addresses in the interleaving memory whose addresses range from 0 to LP-1, the relation between the string of addresses of block b and the string of addresses of block b+1 is:

$$a_{b+1}(n)=Lx(a_b(n)) \text{ modulo } (LP-1) \text{ if } n\neq LP-1,$$

$$a_{b+1}(LP-1)=LP-1.$$

4. Process according to one of the preceding claims, characterized in that there is no reading of data during the writing of the data of the first block.

5. Process according to one of the preceding claims, characterized in that the string of write addresses of the first block is [0; ...; LP-1].

6. Device for generating addresses for interleaving and/or deinterleaving blocks of P packets, each packet including L binary words, characterized in that it comprises means (4, 6) of generating, for a block of order b, a constant $L^{(b-x)}$ modulo (LP-1) with b an integer and x a constant integer less than or equal to b, and means (5) of adding a multiple times m (an integer varying from 0 to LP-1) of the said constant to a base address $(a_b(0))$, each resulting value being taken modulo (LP-1) if the said value is either different from (LP-1) or strictly greater than (LP-1), the result of this addition constituting the read address for block b and the write address for block b+1.

7. Device for generating addresses according to Claim 6, characterized in that it receives a clock pulse (CO) at the frequency of the bytes to be interleaved, the device including a clock divider by P (2) receiving the clock pulse (CO), a clock divider by L (3), receiving as input the output from the divider by P (2), two adders (4, 5) modulo (LP-1), the second adder performing the modulo calculation only if the result of its addition is either different from or strictly greater than (LP-1), as well as a buffer register (6), the first adder (4) possessing a clock input receiving the output signal from the divider by P (2), the two inputs of this first adder (4) respectively receiving the output from the same adder (4) and the output from the buffer register (6), the adder (4) finally possessing a reset input, controlled by the signal from the divider by L (3) or an initialization signal (INIT), the output of the first adder (4) being moreover connected to the input of the said buffer register (6), the latter also possessing a SET input, connected to the initialization signal (INIT) and enabling it to be set to the value 1, as well as a clock input connected to the signal from the divider by L (3), the output of the buffer register (6) being connected to one input of each of the two adders (4, 5), the second adder (5) receiving on its other input its own output, which also constitutes the output of the device and provides the read/write addresses, the clock input of the second adder (5) being connected to the signal CO, the reset input (RESET) of the second adder (5) being connected to a logic OR (7) with two inputs, which receives the output from the divider by L (3) and the initialization signal (INIT).

**Patentansprüche**

1. Verfahren zum Verschachteln von Blöcken mit P Paketen, von denen jedes L binäre Wörter enthält, bei dem, nachdem ein einem Block b-1 entsprechendes Datenfeld bei einer bestimmten Adresse gelesen worden ist, ein dem Block b entsprechendes Datenfeld bei derselben Adresse geschrieben wird,

dadurch gekennzeichnet, daß

die Adressen des Verschachtelungs-Speichers zwischen 0 und LP-1 liegen und das Fortschreiten der Lese/Schreib-Adressen für einen Block b derart ist, daß:

$$a_b(n) = (a_b(n-1) + (L^{(b-x)})) \bmod (LP-1) \text{ für } n \in\ ]\ 0,\ LP-1\ [,\ n \text{ ganzzahlig,}$$

mit

$a_b(0) = 0$
$a_b(LP-1) = LP-1$

und

$b \in [1,\ \infty\ [,\ b$ ganzzahlig
$x \le b,\ x$ ganzzahlig.

2. Verfahren nach Anspruch 1, dadurch gekennzeichnet, daß die Folge der Konstanten $L^{(b-x)}$ im voraus gespeichert wird.

3. Verfahren zum Verschachteln von Blöcken mit P Paketen, jedes enthaltend L binäre Wörter, bei dem ein einem Block b-1 entsprechendes Datenfeld bei einer bestimmten Adresse gelesen worden ist, ein dem Block b entsprechendes Datenfeld bei derselben Adresse eingeschrieben wird,
dadurch gekennzeichnet, daß
dann, wenn $a_b(n)$ die Folge von Lese/Schreib-Adressen in dem Verschachtelungs-Speicher ist, dessen Adressen zwischen 0 und LP-1 liegen, der Zusammenhang zwischen der Folge von Adressen des Blocks b und der Folge von Adressen des Blocks b+1 folgendermaßen ist:

$$a_{b+1}(n) = Lx(a_b(n)) \text{ modulo } (LP-1) \text{ wenn } n \ne LP-1,$$

$$a_{b+1}(LP-1) = LP-1.$$

4. Verfahren nach einem der vorangehenden Ansprüche, dadurch gekennzeichnet, daß während des Schreibens der Daten des ersten Blocks kein Lesen der Daten erfolgt.

5. Verfahren nach einem der vorangehenden Ansprüche, dadurch gekennzeichnet, daß die Folge der Schreibadressen des ersten Blocks folgendermaßen ist: [0; ...; LP-1].

6. Vorrichtung zum Erzeugen der Adressen für die Verschachtelungs- und Entschachtelungs-Blöcke mit P Paketen, wobei jedes Paket L binäre Wörter enthält,
dadurch gekennzeichnet, daß
die Vorrichtung Mittel (4, 6) zum Erzeugen einer Konstanten $L^{(b-x)}$ modulo (LP-1) für einen Block der Ordnung b enthält, wobei b eine ganze Zahl und x eine ganzzahlige Konstante weniger als oder gleich b ist, und Mittel (5) enthält zum Addieren eines Mehrfachen von m (eine ganze Zahl zwischen 0 und LP-1) der Konstanten zu einer Basisadresse $(a_b(0))$, wobei jeder resultierende Wert den Wert Modulo (LP-1) annimmt, wenn der genannte Wert von (LP-1) abweicht oder nennenswert größer ist als (LP-1), wobei das Ergebnis dieser Addition die Leseadresse für den Block b und die Schreibadresse für den Block b+1 darstellt.

7. Vorrichtung zum Erzeugen von Adressen nach Anspruch 6,
dadurch gekennzeichnet, daß
die Vorrichtung einen Taktimpuls (CO) mit der Frequenz der zu verschachtelnden Bytes empfängt, daß die Vorrichtung einen den Taktimpuls CO empfangenden Taktteiler durch P (2) einen Taktteiler durch L (3), der als Eingang den Ausgang von dem Teiler P (2) empfängt, zwei Addierstufen (4, 5) Modulo (LP-1) enthält, wobei die zweite Addierstufe die Modulo-Berechnung nur dann durchführt, wenn das Ergebnis ihrer Addition entweder unterschiedlich von oder nennenswert größer ist als (LP-1), sowie ein Pufferregister (6) enthält, daß die erste Addierstufe (4) einen Takteingang aufweist, der das Ausgangssignal von dem Teiler durch P (2) empfängt, daß die beiden Eingänge der ersten Addierstufe (4) jeweils das Ausgangssignal von derselben Addierstufe (4) und das Ausgangssignal von dem Pufferregister (6) empfangen, daß die Addierstufe (4) schließlich einen Rücksetzeingang zum Rücksetzen auf null aufweist, der durch das Signal von dem Teiler durch L (3) oder ein Auslösesignal (INIT) gesteuert wird, daß der Ausgang der ersten Addierstufe (4) außerdem mit dem Eingang des Pufferregisters (6) verbunden ist, daß dieses auch einen SET-Eingang, der mit dem Auslösesignal (INIT) verbunden ist und auf den Wert 1 gesetzt werden kann, sowie einen Takteingang aufweist, der mit dem Signal von dem Teiler durch L (3) verbunden ist, daß der Ausgang des Pufferregisters (6) mit einem Eingang jeder der beiden Addierstufen (4, 5) verbunden ist, daß die zweite Addierstufe (5) an ihrem anderen Eingang ihren eigenen Ausgang empfängt, der außerdem den Ausgang der Vorrichtung darstellt und die Lese/Schreib-Adressen liefert, daß der Takteingang der zweiten Addierstufe (5) mit dem Signal CO verbunden ist, daß der Rücksetzeingang auf null (RESET) der zweiten Addierstufe (5) mit einem logischen OR-Gatter (7) mit zwei Eingängen verbunden ist, das den Ausgang von dem Teiler L (3) und das Auslösesignal (INIT) empfängt.

FIG.3

FIG.2

FIG.1

Adresse de la mémoire

© C

Adresse d'écriture

$LP + (L-1)P = 2LP \cdot P$

Adresse de lecture

® B
LP
LP.1

$(L-1)P$

® A

© C

2L+1

16
15
14
13
12
11
10
9
8
7 P
6
5
4
3
2
1
0

® D

® A

T

FIG. 4

Temps

FIG. 6

1   2 /P   3 /L   Init   7   X

ADDITION modulo LP-1 reset
X   4

LATCH set
Init   6

reset ADDITION modulo LP-1   5

Ecriture: Bloc # 1 | Bloc # 2 | Bloc # 3 | Bloc # 4 | Bloc # 5 | Bloc # 6

Lecture : | Bloc # 1 | Bloc # 2 | Bloc # 3 | Bloc # 4 | Bloc # 5

Adresse de la mémoire

Temps

FIG. 5

FIG. 7

FIG. 8